(19) Europäisches Patentamt
European Patent Office
Office européen des brevets

(11) **EP 3 637 793 B1**

(12) **FASCICULE DE BREVET EUROPEEN**

(45) Date de publication et mention
de la délivrance du brevet:
**09.12.2020 Bulletin 2020/50**

(51) Int Cl.:
*H04R 3/04* *(2006.01)*       *H04R 29/00* *(2006.01)*
*H03G 5/16* *(2006.01)*       *G06F 1/20* *(2006.01)*
*H04R 3/00* *(2006.01)*       *H03G 7/00* *(2006.01)*
*H04R 9/02* *(2006.01)*

(21) Numéro de dépôt: **19201611.1**

(22) Date de dépôt: **07.10.2019**

(54) **PROCÉDÉ DE CONTRÔLE EN TEMPÉRATURE D'UN ÉQUIPEMENT DE RESTITUTION SONORE, DISPOSITIF ET PROGRAMME D'ORDINATEUR ASSOCIÉS**

TEMPERATURÜBERWACHUNGSVERFAHREN EINER KLANGWIEDERGABEAUSRÜSTUNG, ENTSPRECHENDE VORRICHTUNG UND ENTSPRECHENDES COMPUTERPROGRAMM

METHOD FOR CONTROLLING THE TEMPERATURE OF SOUND PLAYBACK EQUIPMENT, CORRESPONDING DEVICE AND COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.10.2018 FR 1859324**

(43) Date de publication de la demande:
**15.04.2020 Bulletin 2020/16**

(73) Titulaire: **Devialet**
**75001 Paris (FR)**

(72) Inventeur: **HOANG CO THUY, Vu**
**75012 Paris (FR)**

(74) Mandataire: **Lavoix**
**2, place d'Estienne d'Orves**
**75441 Paris Cedex 09 (FR)**

(56) Documents cités:
**CN-A- 107 431 858       GB-A- 2 542 643**
**US-A1- 2013 083 928     US-A1- 2018 136 051**

**Description**

La présente invention concerne un équipement de restitution sonore comportant une entrée de réception d'un signal d'entrée audio à restituer, un haut-parleur, une chaîne de traitement et d'amplification comportant des composants électroniques dont au moins un amplificateur propre à exciter le haut-parleur, un radiateur adapté pour dissiper la chaleur de l'enceinte vers l'extérieur de l'équipement.

Lorsqu'un tel équipement de restitution est utilisé en continu sur une longue période, il a tendance à devenir très chaud, notamment au niveau de l'interface entre le radiateur et l'extérieur de l'équipement. Il est souhaitable toutefois de limiter la température en surface et notamment au niveau du radiateur, d'une part pour le confort de l'utilisateur de l'équipement, d'autre part pour que l'équipement soit conforme à des normes en vigueur.

La présente invention vise à proposer une solution permettant de contrôler la température du radiateur.

A cet effet, suivant un premier aspect, l'invention propose un procédé de contrôle en température d'un équipement de restitution sonore du type précité caractérisé en ce qu'il comprend les étapes mises en œuvre par un module électronique de contrôle de température et consistant à :

a/ collecter des données de température indiquant la température du radiateur ;

b/ déterminer la puissance thermique $P_{rad}$ fournie au radiateur par les composants de la chaîne de traitement et d'amplification en fonction d'une évaluation de la puissance thermique $P_g$ émise par au moins le haut-parleur et par les composants de la chaîne de traitement et d'amplification pour le signal d'entrée audio à restituer, dudit signal d'entrée audio à restituer et d'un modèle de transfert thermique au sein de l'équipement de restitution sonore, puis estimer la température extérieure à l'équipement de restitution sonore par une formule donnant la température extérieure $T_{ext}$ en fonction de la température du radiateur $T_{rad}$ indiquée par les données collectées $T_{rad}$, de la puissance thermique fournie en entrée du radiateur déterminée $P_{rad}$ et de la résistance thermique du radiateur $R_{th}$ ;

c/ calculer la puissance thermique maximale $P_{rad\_max}$ qui peut être fournie au radiateur en fonction de la température extérieure estimée et d'un seuil de température de radiateur maximale $T_{rad\_max}$ et en fonction de ladite formule ;

d/ déterminer la puissance thermique maximale à émettre par au moins le haut-parleur et par les composants de la chaîne de traitement et d'amplification pour le signal d'entrée audio à restituer, en fonction de la puissance thermique maximale $P_{rad\_max}$ calculée, et dudit modèle de transfert thermique au sein de l'équipement de restitution sonore ;

e/ déterminer, en fonction de ladite puissance thermique maximale à émettre déterminée, au moins une commande contrôlant le fonctionnement du haut-parleur ou de la chaîne de traitement et d'amplification de manière à ce que la puissance thermique émise par au moins le haut-parleur et par les composants de la chaîne de traitement et d'amplification pour le signal d'entrée audio à restituer soit inférieure à ladite puissance thermique maximale à émettre déterminée.

L'invention permet ainsi de proposer une solution permettant de contrôler la température du radiateur en tirant au maximum partie des caractéristiques de l'équipement de restitution sonores et du signal d'entrée audio à restituer.

Dans des modes de réalisation, le procédé de contrôle en température suivant l'invention comporte en outre une ou plusieurs des caractéristiques suivantes :

- la formule à l'étape b est $T_{ext} = T_{rad} - P_{rad} \cdot R_{th}$ et selon lequel à l'étape c, la puissance thermique maximale $P_{rad\_max}$ est égale à $(T_{rad\_max} - Text)/ Rth$ ;
- le modèle de transfert thermique au sein de l'équipement de restitution sonore est défini par la fonction $P_{rad} = (P_g - R_{rth}/R_g * T_{mes} - C_{th} * d(T_{mes})/dt)/(1 + R_{th}/R_g)$, où $R_g$ est la valeur résistance thermique entre l'équipement de restitution sonore considéré en tant que source de chaleur et l'extérieur dudit équipement, $T_{mes}$ est une température mesurée indiquant la température du radiateur, $C_{th}$ est une valeur de capacité représentant le stockage d'énergie thermique et définissant le temps de montée en température, $d(T_{mes})/dt$ est la dérivée temporelle de $T_{mes}$ ;
- lesdites étapes sont mises en œuvre cycliquement, à une période T dont la valeur est comprise dans la plage [0,1 s, 1 s] ;
- une commande déterminée à l'étape e comprend :

  - une valeur de volume maximal de restitution du signal audio calculée en fonction de la puissance thermique maximale à émettre déterminée ;
  - un niveau maximal en sortie de l'amplificateur calculé en fonction de la puissance thermique maximale à émettre déterminée ;

- une valeur limite d'excursion du haut-parleur calculée en fonction de la puissance thermique maximale à émettre déterminée.

Suivant un deuxième aspect, la présente invention propose un dispositif électronique de contrôle en température d'un équipement de restitution sonore comportant une entrée de réception d'un signal d'entrée audio à restituer, un haut-parleur, une chaîne de traitement et d'amplification comportant des composants électroniques dont au moins un amplificateur propre à exciter le haut-parleur et un radiateur adapté pour dissiper la chaleur de l'enceinte vers l'extérieur de l'équipement,

ledit dispositif étant adapté pour collecter des données de température indiquant la température du radiateur, pour déterminer la puissance thermique $P_{rad}$ fournie au radiateur par les composants de la chaîne de traitement et d'amplification en fonction d'une évaluation de la puissance thermique $P_g$ émise par au moins le haut-parleur et par les composants de la chaîne de traitement et d'amplification pour le signal d'entrée audio à restituer, dudit signal d'entrée audio à restituer et d'un modèle de transfert thermique au sein de l'équipement de restitution sonore, pour estimer la température extérieure à l'équipement de restitution sonore par une formule donnant la température extérieure $T_{ext}$ en fonction de la température du radiateur $T_{rad}$ indiquée par les données collectées $T_{rad}$, de la puissance thermique fournie en entrée du radiateur déterminée $P_{rad}$ et de la résistance thermique du radiateur Rth ;

ledit dispositif étant adapté pour calculer la puissance thermique maximale $P_{rad\_max}$ qui peut être fournie au radiateur en fonction de la température extérieure estimée et d'un seuil de température de radiateur maximale $T_{rad\_max}$ et en fonction de ladite formule, pour déterminer la puissance thermique maximale à émettre par au moins le haut-parleur et par les composants de la chaîne de traitement et d'amplification pour le signal d'entrée audio à restituer, en fonction de la puissance thermique maximale $P_{rad\_max}$ calculée, et dudit modèle de transfert thermique au sein de l'équipement de restitution sonore ;

ledit dispositif étant adapté pour déterminer, en fonction de ladite puissance thermique maximale à émettre déterminée, au moins une commande de contrôle du fonctionnement du haut-parleur ou de la chaîne de traitement et d'amplification de manière à ce que la puissance thermique émise par au moins le haut-parleur et par les composants de la chaîne de traitement et d'amplification pour le signal d'entrée audio à restituer soit inférieure à ladite puissance thermique maximale à émettre déterminée.

Dans des modes de réalisation, le dispositif électronique de contrôle en température suivant l'invention comporte en outre une ou plusieurs des caractéristiques suivantes :

- il est adapté pour estimer la température extérieure en fonction de la formule d'estimation de la température extérieure $T_{ext} = T_{rad} - P_{rad} \cdot R_{th}$ et adapté pour déterminer la puissance thermique maximale $P_{rad\_max}$ comme égale à ($T_{rad\_max}$ -$T_{ext}$)/ $R_{th}$. ;
- ledit modèle de transfert thermique au sein de l'équipement de restitution sonore est défini par la fonction $P_{rad} = (P_g - R_{rth}/R_g * T_{mes} - C_{th} * d(T_{mes})/dt))/(1 + R_{th}/R_g)$, où $R_g$ est la valeur résistance thermique entre l'équipement de restitution sonore considéré en tant que source de chaleur et l'extérieur dudit équipement, $T_{mes}$ est une température mesurée indiquant la température du radiateur, $C_{th}$ est une valeur de capacité représentant le stockage d'énergie thermique et définissant le temps de montée en température, $d(T_{mes})/dt$ est la dérivée temporelle de $T_{mes}$ ;
- ladite commande comprend :

    - une valeur de volume maximal de restitution du signal audio calculée en fonction de la puissance thermique maximale à émettre déterminée ;
    - un niveau maximal en sortie de l'amplificateur calculé en fonction de la puissance thermique maximale à émettre déterminée ;
    - une valeur limite d'excursion du haut parleur calculée en fonction de la puissance thermique maximale à émettre déterminée.

Suivant un troisième aspect, la présente invention propose un programme d'ordinateur comportant des instructions logicielles qui, lorsqu'elles sont exécutées par un ordinateur, mettent en œuvre un procédé suivant le premier aspect.

Ces caractéristiques et avantages de l'invention apparaîtront à la lecture de la description qui va suivre, donnée uniquement à titre d'exemple, et faite en référence aux dessins annexés, sur lesquels :

- la figure 1 représente une vue d'un équipement de restitution sonore dans un mode de réalisation de l'invention ;
- la figure 2 est un schéma correspondant au modèle de dissipation thermique correspondant à l'équipement représenté en figure 1 dans un mode de réalisation de l'invention ;
- la figure 3 est un organigramme d'étapes mises en œuvre dans un mode de réalisation de l'invention.

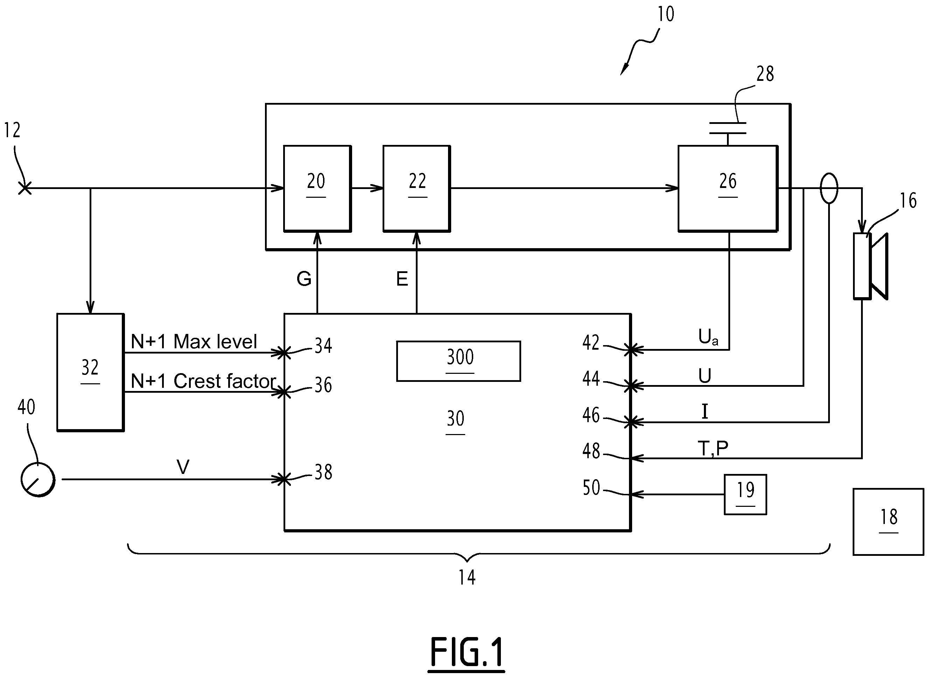

L'équipement de restitution sonore 10 illustré sur la figure 1 comporte une entrée 12 de réception d'un signal audio à restituer, une chaîne 14 de traitement et d'amplification du signal, un haut-parleur 16, un radiateur 18 et un capteur de température 19.

Le capteur de températures 19 est adapté pour effectuer des mesures de température du radiateur 18.

Le haut-parleur 16 est par exemple un haut-parleur de type électrodynamique comportant un aimant, une membrane maintenue par une suspension périphérique et une bobine d'excitation de la membrane suspendue par une pièce appelée communément spider. La membrane est mobile sous l'action conjuguée de l'aimant et d'un courant électrique variable traversant la bobine.

Le haut-parleur 16 est logé dans la paroi d'un volume d'air, formant ainsi une enceinte acoustique close, à évent, ou à haut-parleur passif. Le haut-parleur 16 est caractérisé par les paramètres physiques suivants correspondant aux caractéristiques physiques réelles du haut-parleur sans correction électronique du signal d'excitation : I : longueur du fil de la bobine, $R_e$ : résistance de la bobine, $L_e$ : inductance de la bobine, $M_m$ : masse mobile du haut-parleur, $C_m$ : souplesse ou compliance (inverse de la raideur du diaphragme et du joint), $S_d$ : surface du piston formé par la membrane et la partie du joint périphérique, B : champ magnétique de l'aimant, $R_m$ : perte mécanique dans le haut-parleur.

La chaîne de traitement et d'amplification 14 comporte un étage de préamplification 20 permettant l'application d'un gain global G au signal d'entrée audio à amplifier. L'étage de préamplification 20 est relié en entrée à l'entrée 12.

La sortie de l'étage de préamplification 20 est reliée à l'entrée d'un égaliseur 22 d'amplitude dépendant de la fréquence, propre à assurer un filtrage suivant une courbe de réponse en fréquence prédéterminée E formant une consigne.

Enfin, la chaîne d'amplification et de traitement 14 comporte un amplificateur de puissance 26 dont l'entrée est reliée en sortie de l'égaliseur 22et dont la sortie est reliée au haut-parleur 16 et une alimentation électrique 28. L'amplificateur 26 est une source de tension ayant une faible impédance de sortie, inférieure à 10 mΩ. De préférence, l'amplificateur 26 est constitué d'un amplificateur tel que décrit dans la demande de brevet FR 2 873 872.

La chaîne de traitement et d'amplification 14 comporte une unité de commande principale électronique 30 assurant notamment le pilotage des étages de préamplification 20 et d'égalisation 22.

L'unité de commande principale 30 est reliée à une unité 32 de prétraitement du signal d'entrée, laquelle est reliée directement à l'entrée 12. L'unité de prétraitement 32 est propre à déterminer en continu le niveau instantané maximal en amplitude du signal acoustique d'entrée à partir d'une analyse fréquentielle multibande. Ce niveau instantané maximal noté *N+1 Max Level* est fourni sur une entrée 34 de l'unité de commande principale 30.

De même, l'unité de prétraitement 32 est propre à fournir, sur une entrée 36 de l'unité de commande principale 30, un facteur de crête du signal d'entrée audio résultant d'une analyse fréquentielle multibande. Ce facteur de crête est noté *N+ 1 Crest Factor.*

Sur une entrée 38, l'unité de commande principale 30 est reliée à une interface utilisateur 40, permettant de fixer une consigne de volume V représentative du niveau sonore escompté pour le signal audio restitué par le haut-parleur 16.

Afin d'assurer la commande notamment des étages 20 et 22, l'unité de commande principale 30 reçoit en outre sur une entrée 42, une valeur représentative de la tension $U_a$ d'alimentation de l'amplificateur 26 fournie par l'alimentation 28. Elle reçoit également sur des entrées 44 et 46 des valeurs représentatives, respectivement de la tension U et du courant I appliqués aux bornes du haut-parleur 16. Les valeurs reçues sur les entrées 42, 44 et 46 sont mesurées directement sur l'amplificateur 26 ou en sortie de celui-ci par tous moyens connus adaptés.

En outre, l'unité de commande principale 30 reçoit sur l'entrée 48 des valeurs représentatives de l'état du haut-parleur et notamment de sa température T de fonctionnement et de la position P de la membrane du haut-parleur.

L'unité de commande principale 30 reçoit sur l'entrée 50 des valeurs représentatives de la température $T_{mes}$ mesurées par le capteur de température 19.

L'unité de commande principale 30 est propre, à partir d'une partie ou de la totalité à définir des signaux de commande pour les étages 20 et 22.

En particulier, elle est propre à calculer le gain global G appliquée à l'entrée de l'étage de préamplification 20 ainsi que la courbe E d'égalisation de réponse en fréquence appliquée à l'étage d'égalisation 22.

De manière globale, elle calcule et commande ainsi une tension de consigne à fournir au haut-parleur, en fonction d'une réponse en fréquence cible à obtenir.

L'unité de prétraitement 32 est illustrée en détail sur la figure 1. On retrouve sur cette figure l'entrée 12 pour le signal audio à restituer et les entrées 34, 36 de l'unité de commande principale 30.

L'unité de prétraitement 32 est propre à assurer une analyse du signal d'entrée en séparant le spectre du signal en plusieurs bandes de fréquences prédéfinies.

Elle comporte un module de calcul d'une transformée de Fourier rapide du signal audio dont la sortie est reliée à un analyseur de bande. Elle comporte en outre un analyseur de facteur de crête et de détermination du niveau global maximum.

L'analyseur est propre à fournir, à l'entrée 34, N+1 niveaux d'intensité maximaux calculés pour N fréquences prédéterminées du signal et un niveau maximal pour l'ensemble du signal. L'analyseur est propre à fournir à partir du signal audio, sur l'entrée 36, N+1 facteurs de crête pour les mêmes fréquences d'analyse considérées pour le signal global.

Les modes de traitement des signaux mis en œuvre dans l'unité de commande principale 30 vont maintenant être décrits.

Le gain global G appliqué à l'étage de préamplification 20 est une fonction de la consigne de volume V reçue sur l'entrée 38 comme connue en soi. Elle ne sera pas décrite plus en détail.

La consigne d'égalisation E appliquée à l'égaliseur 22 prend en compte deux composantes.

Comme connue en soi, elle assure d'abord une compensation de l'affaiblissement psycho-acoustique. En fonction de la consigne de volume V reçue sur l'entrée 38, la réponse en fréquence est ajustée pour compenser les pertes en basses fréquences inférieures à 120 Hz et la sensation d'affaiblissement des hautes fréquences supérieures à 5 kHz aux volumes d'écoute faible. L'ajustement de la courbe de réponse en fréquence est réalisé selon des courbes de contours d'égalisation connues.

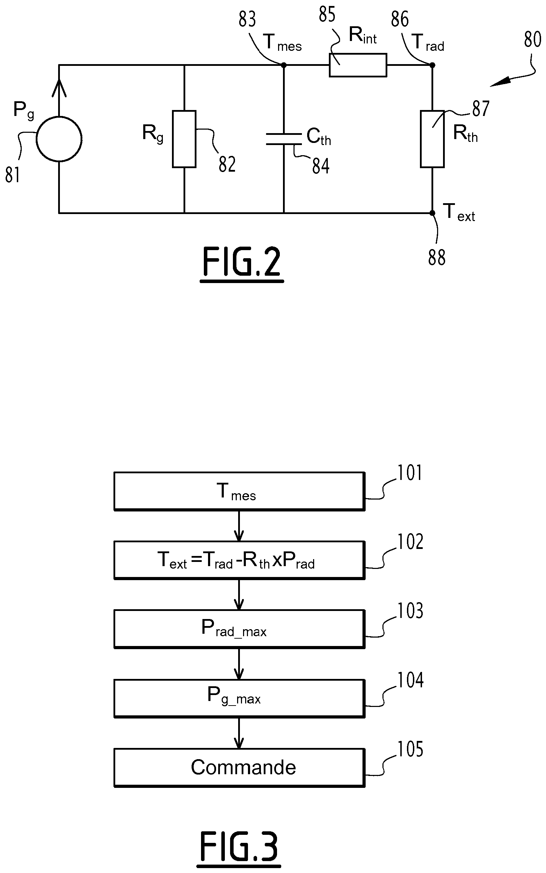

La figure 2 est un schéma définissant le modèle de dissipation thermique et d'évolution de la température de l'équipement 10 représenté en figure 1 dans un mode de réalisation de l'invention. Ce schéma traduit le schéma thermique 80, par équivalence avec un schéma électrique, de l'équipement 10 considéré comme une source de chaleur, où :

- $P_g$ est la somme de la puissance thermique émise par le générateur de puissance 81, i.e. l'ensemble des sources de chaleur présentes dans l'équipement 10 : les équipements acoustiques et électroniques, notamment le haut-parleur 16, l'amplificateur 26, l'alimentation 28 etc ; cette puissance thermique est pour partie fournie en entrée du radiateur 18, le reste étant dissipé autrement ;
- $R_g$ est la valeur de la résistance thermique 82 entre la source de chaleur représentée par l'équipement 10, et l'extérieur ;
- $T_{mes}$ est la température mesurée au point de mesure 83 du capteur 19 ;
- $C_{th}$ est la valeur d'une capacité 84, qui représente le stockage d'énergie et définit le temps de montée en température de l'équipement 10 (typiquement le volume d'air à l'intérieur de l'équipement 10) ;
- $R_{int}$ est la valeur de la résistance thermique 85 entre l'endroit où est mesurée la température, et la température réelle du radiateur (pour des raisons d'optimisation de l'occupation de l'espace et éviter la présence de fils supplémentaires à l'intérieur de l'équipement 10, dans le mode de réalisation considéré, le capteur est soudé sur une carte électronique, et non pas placé directement sur le radiateur) ;
- $T_{rad}$ est la température du radiateur 18 en un point 86 du radiateur 18 ;
- $R_{th}$ est la valeur de la résistance thermique du radiateur 18 ;
- $T_{ext}$ est la température extérieure, i.e. la température ambiante qui règne dans la pièce au sein de laquelle l'équipement 10 est localisé, par exemple en un point 88.

D'autres modèles, plus ou moins complexes peuvent servir de base pour la mise en œuvre de l'invention, par exemple sur la base du modèle décrit dans le document Nonlinear Modeling of the Heat Transfer in Loudspeakers, W. Klippel.

Dans un mode de réalisation de l'invention, l'unité de commande principale 30 comprend un module de contrôle de température 300, adapté pour contrôler la température régnant au sein de l'équipement 10 et plus particulièrement dans le cas considéré, pour contrôler la température du radiateur 18 et commander le fonctionnement de l'équipement de manière à ce que la température du radiateur Trad reste inférieur à un seuil de température, noté $T_{rad\_max}$, par exemple compris dans la plage [55 °C, 80°C, par exemple pris égal ici à 70 °C.

Dans un mode de réalisation, le module de contrôle de température 300 est adapté pour implémenter les opérations décrites ci-dessous en référence à la figure 3, pendant qu'un signal audio appliqué sur l'entrée 12 est restitué, pour d'abord déterminer la puissance thermique maximale qui peut être générée par l'équipement 10 pour ensuite piloter le fonctionnement de l'équipement 10 afin de limiter la température du radiateur 18 en-dessous de $T_{rad\_max}$.

Ces opérations sont réitérées à la fréquence F, avec F comprise dans la plage [1 Hz, 10 Hz].

Dans une étape 101, le module de contrôle de température 300 collecte la dernière mesure de température $T_{mes}$ réalisée par le capteur 19 indiquant la température du radiateur 18.

Dans une étape 102, tout d'abord le module de contrôle de température 300 estime la température extérieure à partir de la formule :

$$T_{ext} = T_{rad} - P_{rad} * R_{th} \tag{1}$$

où $P_{rad}$ est la puissance thermique fournie en entrée du radiateur 18 déterminée.

Pour cela, le module de contrôle de température 300 détermine d'abord la puissance thermique $P_{rad}$ fournie au radiateur par les composants électroniques de la chaîne de traitement et d'amplification, sur la base du modèle de transfert thermique au sein de l'équipement 10 représenté en figure 2 :

$$P_{rad} = {}_{(}P_g - R_{th}/R_g * T_{mes} - C_{th} * d(T_{mes})/dt) /(1+ R_{th}/R_g) \qquad (2)$$

Où $d(T_{mes})/dt$ est la dérivée de $T_{mes}$ par rapport au temps t.

Pour calculer la valeur de $P_{rad}$ à partir de la formule (2), le module de contrôle de température 300 évalue tout d'abord $P_g$ en fonction du signal audio courant appliqué en entrée 12 et de l'égalité

$$P_g = 1/RendementElec * 1/RendementAmpli * Php + Pidle \qquad (3)$$

où

Php est la puissance thermique dissipée par le haut-parleur 16 calculée à partir du signal audio 12 ;
Pidle est une puissance statique thermique composants électroniques considérés ;
RendementElec est le rendement du bloc alimentation ;
RendementAmpli est le rendement du bloc amplification ;
où le rendement d'un bloc est égal à la puissance restituée en sortie du bloc considéré divisée par la puissance qui lui est fournie en entrée, et est donc inférieur ou égal à 1. Puis une fois $P_{rad}$ calculé à l'aide de la formule (2), la température $T_{ext}$ est calculée via la formule (1).

Dans une étape 103, le module de contrôle de température 300 calcule ensuite la puissance thermique maximale $P_{rad\_max}$ qui peut être fournie au radiateur 18 en fonction de la température extérieure $T_{ext}$ estimée à l'étape 102 et du seuil de température de radiateur maximale $T_{rad\_max}$ :

$$P_{rad\_max} = (T_{rad\_max} - T_{ext})/ R_{th} \,.$$

Puis dans une étape 104, le module de contrôle de température 300 détermine la puissance thermique maximale $P_{g\_max}$ à émettre par le haut-parleur 18 et par les composants de la chaîne de traitement et d'amplification 14 pour le signal d'entrée audio à restituer, en fonction de la puissance thermique maximale $P_{rad\_max}$ calculée et du modèle de transfert thermique, en déduisant $P_{g\_max}$ à partir de l'égalité suivante :

$$P_{rad\ max} = {}_{(}P_{g\ max} - R_{th}/R_g * T_{mes} - C_{th} * d(T_{mes})/dt) /(1+ R_{th}/R_g) \qquad ,$$

Dans une étape 105, le module de contrôle de température 300 détermine, en fonction de cette puissance thermique maximale à émettre déterminée $P_{g\_max}$, au moins une commande contrôlant le fonctionnement du haut-parleur 16 ou la chaîne de traitement et d'amplification (14) de manière à ce que la puissance thermique $P_g$ courante effectivement émise par au moins le haut-parleur et par les composants de la chaîne de traitement et d'amplification pour le signal d'entrée audio à restituer reste inférieure à $P_{g\_max}$.
Plusieurs types de commandes sont possibles, qui peuvent être combinées :

- par exemple, une commande d'adaptation du volume maximal de restitution du signal audio $V_{max}$ : en calculant un gain d'atténuation g égal à sqrt ($P_{g\_max}/P_g$) où la fonction sqrt est la fonction racine carrée ; ce gain d'atténuation g étant fourni en entrée de l'étage de préamplification 20 où il sera appliqué de manière multiplicative au volume maximal $V_{max}$ défini lorsqu'il n'y a pas de protection thermique/ou
- en adaptant le niveau maximal de tension en sortie de l'amplificateur 26 en fonction de $P_{g\_max}$ : le niveau maximal $V_{out}$ est calculé de façon standard, i.e. comme il est usuellement calculé quand il n'y a pas de protection thermique, puis est multiplié par la consigne du gain g d'atténuation, g=sqrt ($P_{g\_max}/P_g$) et/ou
- une commande limitant l'excursion du haut-parleur 16 (i.e. le déplacement maximum de la membrane du haut-parleur 16) : la valeur de l'excursion maximum est extraite d'une table préalablement définie (via des expérimentations), par rapport au rapport entre $Pg_{max}$ et $P_g$ ; la consigne d'excursion maximum résultante est fournie par le module de contrôle de température 300 de l'unité de commande 30 au haut-parleur 16.

Dans le mode de réalisation considéré, l'unité de commande 30 comporte une mémoire et un processeur (non représenté). Et le module de contrôle de température 300 est alors par exemple réalisé sous forme d'un logiciel exécutable par le processeur. La mémoire de l'unité de commande stocke alors ce logiciel, qui lorsqu'il est exécuté sur le processeur de l'unité de commande, met en œuvre les étapes indiquées en figure 3.

Dans un autre mode de réalisation, le module de contrôle de température 300 et/ou l'unité de commande principale 30 sont réalisés sous forme d'un composant logique programmable, tel qu'un FPGA (de l'anglais *Field Programmable Gate Array),* ou encore sous forme d'un circuit intégré dédié, tel qu'un ASIC (de l'anglais *Applications Specific Integrated Circuit*).

Le modèle de dissipation thermique ainsi considéré dans le mode de réalisation décrit prend en compte tant les éléments mécaniques, notamment haut-parleur, que les éléments électronique de l'enceinte audio 10.

La présente invention permet ainsi de contrôler la température de l'équipement 10 et de la limiter en-dessous d'un seuil prédéterminé de façon optimale quant à la qualité du signal restitué.

**Revendications**

1. Procédé de contrôle en température d'un équipement de restitution sonore (10) comportant :

   - une entrée (12) de réception d'un signal d'entrée audio à restituer ;
   - un haut-parleur (16) ; logé dans une enceinte;
   - une chaîne de traitement et d'amplification (14) comportant des composants électroniques dont au moins un amplificateur (26) propre à exciter le haut-parleur (16),
   - un radiateur adapté pour dissiper la chaleur de l'enceinte vers l'extérieur de l'équipement ;

   ledit procédé étant **caractérisé en ce qu'**il comprend les étapes mises en œuvre par un module électronique de contrôle de température et consistant à :

   a/ collecter des données de température indiquant la température du radiateur ;
   b/ déterminer la puissance thermique $P_{rad}$ fournie au radiateur par les composants de la chaîne de traitement et d'amplification en fonction d'une évaluation de la puissance thermique $P_g$ émise par au moins le haut-parleur et par les composants de la chaîne de traitement et d'amplification pour le signal d'entrée audio à restituer, dudit signal d'entrée audio à restituer et d'un modèle de transfert thermique au sein de l'équipement de restitution sonore, puis estimer la température extérieure à l'équipement de restitution sonore (10) par une formule donnant la température extérieure $T_{ext}$ en fonction de la température du radiateur $T_{rad}$ indiquée par les données collectées $T_{rad}$, de la puissance thermique fournie en entrée du radiateur déterminée $P_{rad}$ et de la résistance thermique du radiateur $R_{th}$ ;
   c/ calculer la puissance thermique maximale $P_{rad\_max}$ qui peut être fournie au radiateur en fonction de la température extérieure estimée et d'un seuil de température de radiateur maximale $T_{rad\_max}$ et en fonction de ladite formule ;
   d/ déterminer la puissance thermique maximale à émettre par au moins le haut-parleur et par les composants de la chaîne de traitement et d'amplification pour le signal d'entrée audio à restituer, en fonction de la puissance thermique maximale $P_{rad\_max}$ calculée, et dudit modèle de transfert thermique au sein de l'équipement de restitution sonore ;
   e/ déterminer, en fonction de ladite puissance thermique maximale à émettre déterminée, au moins une commande contrôlant le fonctionnement du haut-parleur (16) ou de la chaîne de traitement et d'amplification (14) de manière à ce que la puissance thermique émise par au moins le haut-parleur et par les composants de la chaîne de traitement et d'amplification pour le signal d'entrée audio à restituer soit inférieure à ladite puissance thermique maximale à émettre déterminée.

2. Procédé de contrôle en température d'un équipement de restitution sonore (10) selon la revendication 1, selon lequel la formule à l'étape b est $T_{ext} = T_{rad} - P_{rad} \cdot R_{th}$ et selon lequel à l'étape c, la puissance thermique maximale $P_{rad\_max}$ est égale à $(T_{rad\_max} - T_{ext}) / R_{th}$.

3. Procédé de contrôle en température d'un équipement de restitution sonore (10) selon la revendication 1 ou 2, selon lequel le modèle de transfert thermique au sein de l'équipement de restitution sonore est défini par la fonction $P_{rad} = (P_g - R_{rth}/R_g * T_{mes} - C_{th} * d(T_{mes})/dt))/(1 + R_{th}/R_g)$, où $R_g$ est la valeur résistance thermique entre l'équipement de restitution sonore considéré en tant que source de chaleur et l'extérieur dudit équipement, $T_{mes}$ est une température mesurée indiquant la température du radiateur, $C_{th}$ est une valeur de capacité représentant le stockage d'énergie thermique et définissant le temps de montée en température, $d(T_{mes})/dt$ est la dérivée temporelle de $T_{mes}$.

4. Procédé selon l'une quelconque des revendications précédentes, selon lequel lesdites étapes sont mises en œuvre cycliquement, à une période T dont la valeur est comprise dans la plage [0,1 s, 1 s].

5. Procédé selon l'une quelconque des revendications précédentes, selon lequel une commande déterminée à l'étape e comprend :

- une valeur de volume maximal de restitution du signal audio calculée en fonction de la puissance thermique maximale à émettre déterminée ;
- un niveau maximal en sortie de l'amplificateur calculé en fonction de la puissance thermique maximale à émettre déterminée ;
- une valeur limite d'excursion du haut parleur calculée en fonction de la puissance thermique maximale à émettre déterminée ;

6. Programme d'ordinateur comportant des instructions logicielles qui, lorsqu'elles sont exécutées par un ordinateur, mettent en œuvre un procédé selon l'une quelconque des revendications précédentes.

7. Dispositif électronique (300) de contrôle en température d'un équipement de restitution sonore (10) comportant une entrée (12) de réception d'un signal d'entrée audio à restituer, un haut-parleur (16) logé dans une enceinte, une chaîne de traitement et d'amplification (14) comportant des composants électroniques dont au moins un amplificateur (26) propre à exciter le haut-parleur (16) et un radiateur (18) adapté pour dissiper la chaleur de l'enceinte vers l'extérieur de l'équipement,
ledit dispositif étant adapté pour collecter des données de température indiquant la température du radiateur, pour déterminer la puissance thermique $P_{rad}$ fournie au radiateur par les composants de la chaîne de traitement et d'amplification en fonction d'une évaluation de la puissance thermique $P_g$ émise par au moins le haut-parleur et par les composants de la chaîne de traitement et d'amplification pour le signal d'entrée audio à restituer, dudit signal d'entrée audio à restituer et d'un modèle de transfert thermique au sein de l'équipement de restitution sonore, pour estimer la température extérieure à l'équipement de restitution sonore (10) par une formule donnant la température extérieure $T_{ext}$ en fonction de la température du radiateur $T_{rad}$ indiquée par les données collectées $T_{rad}$, de la puissance thermique fournie en entrée du radiateur déterminée $P_{rad}$ et de la résistance thermique du radiateur $R_{th}$ ;
ledit dispositif étant adapté pour calculer la puissance thermique maximale $P_{rad\_max}$ qui peut être fournie au radiateur en fonction de la température extérieure estimée et d'un seuil de température de radiateur maximale $T_{rad\_max}$ et en fonction de ladite formule, pour déterminer la puissance thermique maximale à émettre par au moins le haut-parleur et par les composants de la chaîne de traitement et d'amplification pour le signal d'entrée audio à restituer, en fonction de la puissance thermique maximale $P_{rad\_max}$ calculée, et dudit modèle de transfert thermique au sein de l'équipement de restitution sonore ;
ledit dispositif étant adapté pour déterminer, en fonction de ladite puissance thermique maximale à émettre déterminée, au moins une commande de contrôle du fonctionnement du haut-parleur (16) ou de la chaîne de traitement et d'amplification (14) de manière à ce que la puissance thermique émise par au moins le haut-parleur et par les composants de la chaîne de traitement et d'amplification pour le signal d'entrée audio à restituer soit inférieure à ladite puissance thermique maximale à émettre déterminée.

8. Dispositif électronique de contrôle en température d'un équipement de restitution sonore (10) selon la revendication 7, adapté pour estimer la température extérieure en fonction de la formule d'estimation de la température extérieure $T_{ext} = T_{rad} - P_{rad} \cdot R_{th}$ et adapté pour déterminer la puissance thermique maximale $P_{rad\_max}$ comme égale à $(T_{rad\_max} - T_{ext})/R_{th}$.

9. Dispositif électronique de contrôle en température d'un équipement de restitution sonore (10) selon la revendication 7 ou 8, dans lequel ledit modèle de transfert thermique au sein de l'équipement de restitution sonore est défini par la fonction $P_{rad} = (P_g - R_{rth}/R_g * T_{mes} - C_{th} * d(T_{mes})/dt))/(1+ R_{th}/R_g)$, où $R_g$ est la valeur résistance thermique entre l'équipement de restitution sonore considéré en tant que source de chaleur et l'extérieur dudit équipement, $T_{mes}$ est une température mesurée indiquant la température du radiateur, $C_{th}$ est une valeur de capacité représentant le stockage d'énergie thermique et définissant le temps de montée en température, $d(T_{mes})/dt$ est la dérivée temporelle de $T_{mes}$.

10. Dispositif électronique de contrôle en température d'un équipement de restitution sonore (10) selon l'une quelconque des revendications 7 à 9, selon lequel ladite commande comprend :

- une valeur de volume maximal de restitution du signal audio calculée en fonction de la puissance thermique maximale à émettre déterminée ;

- un niveau maximal en sortie de l'amplificateur calculé en fonction de la puissance thermique maximale à émettre déterminée ;
- une valeur limite d'excursion du haut-parleur calculée en fonction de la puissance thermique maximale à émettre déterminée.

**11.** Equipement de restitution sonore (10) comportant une entrée (12) de réception d'un signal d'entrée audio à restituer, un haut-parleur (16) logé dans une enceinte, J une chaîne de traitement et d'amplification (14) comportant des composants électroniques dont au moins un amplificateur (26) propre à exciter le haut-parleur (16), un radiateur adapté pour dissiper la chaleur de l'enceinte vers l'extérieur de l'équipement, et un dispositif électronique de contrôle en température selon l'une des revendications 7 à 10.

**Patentansprüche**

**1.** Verfahren zur Temperatursteuerung einer Einrichtung zur akustischen Wiedergabe (10), aufweisend:

- einen Eingang (12) zum Empfangen eines wiederzugebenden Audioeingangssignals,
- einen Lautsprecher (16), welcher sich in einem Raum befindet,
- eine Kette zur Verarbeitung und zur Verstärkung (14), welche elektronische Komponenten aufweist, darunter mindestens einen Verstärker (26), welcher dazu geeignet ist, den Lautsprecher (16) anzuregen,
- einen Radiator, welcher dazu eingerichtet ist, die Wärme des Raums zur Außenseite der Einrichtung hin abzuführen,

wobei das Verfahren **dadurch gekennzeichnet ist, dass** es die Schritte aufweist, welche durch ein elektronisches Modul zur Steuerung der Temperatur umgesetzt werden und umfassen:

a/ Sammeln von Temperaturdaten, welche die Temperatur des Radiators angeben,
b/ Ermitteln der Wärmeleistung $P_{rad}$, welche durch die Komponenten der Kette zur Verarbeitung und zur Verstärkung an den Radiator zugeführt wird, in Abhängigkeit von einer Evaluierung der Wärmeleistung $P_g$, welche durch mindestens den Lautsprecher und durch die Komponenten der Kette zur Verarbeitung und zur Verstärkung für das wiederzugebende Audioeingangssignal emittiert wird, dem wiederzugebenden Audioeingangssignal und einem Modell der Wärmeübertragung innerhalb der Einrichtung zur akustischen Wiedergabe, und dann Ermitteln der Temperatur außerhalb der Einrichtung zur akustischen Wiedergabe (10) durch eine Formel, welche die Außentemperatur $T_{ext}$ in Abhängigkeit von der Radiatortemperatur $T_{rad}$, welche durch die gesammelten Daten $T_{rad}$ angegeben wird, der ermittelten Wärmeleistung $P_{rad}$, welche an den Eingang des Radiators zugeführt wird, und dem Wärmewiderstand des Radiators $R_{th}$ angibt,
c/ Berechnen der Wärmemaximalleistung $P_{rad\_max}$, welche dem Radiator zugeführt werden kann, in Abhängigkeit von der ermittelten Außentemperatur und einem Radiatormaximaltemperatur-Schwellenwert $T_{rad\_max}$ und in Abhängigkeit von der Formel,
d/ Ermitteln der durch mindestens den Lautsprecher und durch die Komponenten der Kette zur Verarbeitung und zur Verstärkung für das wiederzugebende Audioeingangssignal zu emittierenden Wärmemaximalleistung in Abhängigkeit von der berechneten Wärmemaximalleistung $P_{rad\_max}$ und des Modells der Wärmeübertragung innerhalb der Einrichtung zur akustischen Wiedergabe,
e/ Ermitteln, in Abhängigkeit von der ermittelten, zu emittierenden Wärmemaximalleistung, mindestens eines Befehls, welcher den Betrieb des Lautsprechers (16) oder der Kette zur Verarbeitung und zur Verstärkung (14) derart steuert, dass die Wärmeleistung, welche durch mindestens den Lautsprecher und durch die Komponenten der Kette zur Verarbeitung und zur Verstärkung für das wiederzugebende Audioeingangssignal emittiert wird, kleiner als die ermittelte, zu emittierende Wärmemaximalleistung ist.

**2.** Verfahren zur Temperatursteuerung einer Einrichtung zur akustischen Wiedergabe (10) gemäß dem Anspruch 1, wobei die Formel in dem Schritt b $T_{ext} = T_{rad} - Prad.R_{th}$ ist und wobei in dem Schritt c die Wärmemaximalleistung $P_{rad\_max}$ gleich $(T_{rad\_max} - Text)/Rth$ ist.

**3.** Verfahren zur Temperatursteuerung einer Einrichtung zur akustischen Wiedergabe (10) gemäß dem Anspruch 1 oder 2, wobei das Modell der Wärmeübertragung innerhalb der Einrichtung zur akustischen Wiedergabe definiert ist durch die Funktion $P_{rad} = (P_g - R_{th}/R_g * T_{mes} - C_{th} * d(Tmes)/dt))/(1 + R_{th}/R_g)$, wobei Rg der Wärmewiderstandswert zwischen der Einrichtung zur akustischen Wiedergabe, welche als die Wärmequelle angesehen wird, und der Außenseite der Einrichtung, $T_{mes}$ eine gemessene Temperatur, welche die Temperatur des Radiators angibt, ist, $C_{th}$

ein Kapazitätswert, welcher die Speicherung von Wärmeenergie repräsentiert und die Zeit zur Temperatursteigerung definiert, ist, $d(T_{mes})/dt$ die zeitliche Ableitung von $T_{mes}$ ist.

4. Verfahren gemäß irgendeinem der vorhergehenden Ansprüche, wobei die Schritte zyklisch mit einer Periode T, deren Wert in dem Bereich [0,1 s, 1 s] liegt, durchgeführt werden.

5. Verfahren gemäß irgendeinem der vorhergehenden Ansprüche, wobei ein in Schritt e ermittelter Befehl aufweist:

   - einen Wert der maximalen Lautstärke zur Wiedergabe des Audiosignals, welcher in Abhängigkeit von der ermittelten, zu emittierenden Wärmemaximalleistung berechnet wird,
   - ein Maximalniveau am Ausgang des Verstärkers, welches in Abhängigkeit von der ermittelten, zu emittierenden Wärmemaximalleistung berechnet wird,
   - einen Grenzwert der Auslenkung des Lautsprechers, welcher in Abhängigkeit von der ermittelten, zu emittierenden Wärmemaximalleistung berechnet wird,

6. Computerprogramm, welches Softwarebefehle aufweist, die bei deren Ausführung durch einen Computer ein Verfahren gemäß irgendeinem der vorhergehenden Ansprüche umsetzen.

7. Elektronische Vorrichtung (300) zur Temperatursteuerung einer Einrichtung zur akustischen Wiedergabe (10), welche einen Eingang (12) zum Empfangen eines wiederzugebenden Audioeingangssignals, einen Lautsprecher (16), welcher sich in einem Raum befindet, eine Kette zur Verarbeitung und zur Verstärkung (14), welche elektronische Komponenten aufweist, darunter mindestens einen Verstärker (26), welcher dazu geeignet ist, den Lautsprecher (16) anzuregen, und einen Radiator (18), welcher dazu eingerichtet ist, die Wärme des Raums zur Außenseite der Einrichtung hin abzuführen, aufweist,
   wobei die Vorrichtung dazu eingerichtet ist, Temperaturdaten, welche die Temperatur des Radiators angeben, zu sammeln, die Wärmeleistung $P_{rad}$, welche durch die Komponenten der Kette zur Verarbeitung und zur Verstärkung an den Radiator zugeführt wird, in Abhängigkeit von einer Evaluierung der Wärmeleistung $P_g$, welche durch mindestens den Lautsprecher und durch die Komponenten der Kette zur Verarbeitung und zur Verstärkung für das wiederzugebende Audioeingangssignal emittiert wird, dem wiederzugebenden Audioeingangssignal und einem Modell der Wärmeübertragung innerhalb der Einrichtung zur akustischen Wiedergabe zu ermitteln, die Temperatur außerhalb der Einrichtung zur akustischen Wiedergabe (10) durch eine Formel, welche die Außentemperatur $T_{ext}$ in Abhängigkeit von der Radiatortemperatur $T_{rad}$, welche durch die gesammelten Daten $T_{rad}$ angegeben wird, der ermittelten Wärmeleistung $P_{rad}$, welche an den Eingang des Radiators zugeführt wird, und dem Wärmewiderstand des Radiators $R_{th}$ angibt, zu ermitteln,
   wobei die Vorrichtung dazu eingerichtet ist, die Wärmemaximalleistung $P_{rad\_max}$, welche dem Radiator zugeführt werden kann, in Abhängigkeit von der ermittelten Außentemperatur und einem Radiatormaximaltemperatur-Schwellenwert $T_{rad\_max}$ und in Abhängigkeit von der Formel zu berechnen, um die durch mindestens den Lautsprecher und durch die Komponenten der Kette zur Verarbeitung und zur Verstärkung für das wiederzugebende Audioeingangssignal zu emittierende Wärmemaximalleistung in Abhängigkeit von der berechneten Wärmemaximalleistung $P_{rad\_max}$ und des Modells der Wärmeübertragung innerhalb der Einrichtung zur akustischen Wiedergabe, zu ermitteln,
   wobei die Vorrichtung dazu eingerichtet ist, in Abhängigkeit von der ermittelten, zu emittierenden Wärmemaximalleistung mindestens einen Befehl zur Steuerung des Betriebs des Lautsprechers (16) oder der Kette zur Verarbeitung und zur Verstärkung (14), so dass die Wärmeleistung, welche durch mindestens den Lautsprecher und durch die Komponenten der Kette zur Verarbeitung und zur Verstärkung für das wiederzugebende Audioeingangssignal emittiert wird, kleiner als die ermittelte, zu emittierende Wärmemaximalleistung ist, zu ermitteln.

8. Elektronische Vorrichtung zur Temperatursteuerung einer Einrichtung zur akustischen Wiedergabe (10) gemäß dem Anspruch 7, welche dazu eingerichtet ist, die Außentemperatur in Abhängigkeit der Formel zur Ermittlung der Außentemperatur $T_{ext} = Trad - P_{rad}.R_{th}$ zu ermitteln, und dazu eingerichtet ist, die Wärmemaximalleistung $P_{rad\_max}$ gleich $(Trad\_max - Text)/Rth$ zu ermitteln.

9. Elektronische Vorrichtung zur Temperatursteuerung einer Einrichtung zur akustischen Wiedergabe (10) gemäß dem Anspruch 7 oder 8, wobei das Modell der Wärmeübertragung innerhalb der Einrichtung zur akustischen Wiedergabe definiert ist durch die Funktion $P_{rad} = (P_g - R_{rth}/R_g * T_{mes} - C_{th} * d(T_{mes})/dt)/(1 + R_{th}/R_g)$, wobei Rg der Wärmewiderstandswert zwischen der Einrichtung zur akustischen Wiedergabe, welche als die Wärmequelle angesehen wird, und der Außenseite der Einrichtung, $T_{mes}$ eine gemessene Temperatur, welche die Temperatur des Radiators angibt, ist, $C_{th}$ ein Kapazitätswert, welcher die Speicherung von Wärmeenergie repräsentiert und die Zeit zur Temperatursteigerung definiert, ist, $d(T_{mes})/dt$ die zeitliche Ableitung von $T_{mes}$ ist.

10. Elektronische Vorrichtung zur Temperatursteuerung einer Einrichtung zur akustischen Wiedergabe (10) gemäß irgendeinem der Ansprüche 7 bis 9, wobei der Befehl aufweist:

- einen Wert der maximalen Lautstärke zur Wiedergabe des Audiosignals, welcher in Abhängigkeit von der ermittelten, zu emittierenden Wärmemaximalleistung berechnet wird,
- ein Maximalniveau am Ausgang des Verstärkers, welches in Abhängigkeit von der ermittelten, zu emittierenden Wärmemaximalleistung berechnet wird,
- einen Grenzwert der Auslenkung des Lautsprechers, welcher in Abhängigkeit von der ermittelten, zu emittierenden Wärmemaximalleistung berechnet wird,

11. Einrichtung zur akustischen Wiedergabe (10), aufweisend einen Eingang (12) zum Empfangen eines wiederzugebenden Audioeingangssignals, einen Lautsprecher (16), welcher sich in einem Raum befindet, eine Kette zur Verarbeitung und zur Verstärkung (14), welche elektronische Komponenten aufweist, darunter mindestens einen Verstärker (26), welcher dazu geeignet ist, den Lautsprecher (16) anzuregen, einen Radiator (18), welcher dazu eingerichtet ist, die Wärme des Raums zur Außenseite der Einrichtung hin abzuführen, und eine elektronische Vorrichtung zur Temperatursteuerung gemäß irgendeinem der Ansprüche 7 bis 10.

**Claims**

1. Method for controlling the temperature of a piece of sound reproduction equipment (10) comprising:

- an input (12) for receiving an audio input signal to be reproduced;
- a loudspeaker (16) housed in an enclosure;
- a processing and amplification chain (14) comprising electronic components including at least an amplifier (26) capable of exciting the loudspeaker (16),
- a radiator adapted to dissipate the heat from the enclosure to the outside of the piece of equipment;

said method being **characterised in that** it comprises the following steps which are carried out by an electronic temperature-control module and consist in:

a/ collecting temperature data indicating the temperature of the radiator;
b/ determining the thermal power $P_{rad}$ provided to the radiator by the components of the processing and amplification chain as a function of an evaluation of the thermal power $P_g$ emitted by at least the loudspeaker and by the components of the processing and amplification chain for the audio input signal to be reproduced, of said audio input signal to be reproduced and of a model of heat transfer within the piece of sound reproduction equipment, then estimating the temperature outside the piece of sound reproduction equipment (10) by means of a formula which gives the outside temperature $T_{ext}$ as a function of the temperature of the radiator $T_{rad}$ indicated by the collected data $T_{rad}$, of the determined thermal power supplied at the input of the radiator $P_{rad}$ and of the thermal resistance of the radiator $R_{th}$;
c/ calculating the maximum thermal power $P_{rad\_max}$ which can be supplied to the radiator as a function of the estimated outside temperature and of a maximum radiator temperature threshold Trad max and as a function of said formula;
d/ determining the maximum thermal power to be emitted by at least the loudspeaker and by the components of the processing and amplification chain for the audio input signal to be reproduced, as a function of the calculated maximum thermal power $P_{rad\_max}$ and of said model of heat transfer within the piece of sound reproduction equipment;
e/ determining, as a function of said determined maximum thermal power to be emitted, at least one command controlling the operation of the loudspeaker (16) or of the processing and amplification chain (14) such that the thermal power emitted by at least the loudspeaker and by the components of the processing and amplification chain for the audio input signal to be reproduced is below said determined maximum thermal power to be emitted.

2. Method for controlling the temperature of a piece of sound reproduction equipment (10) according to claim 1, according to which the formula in step b is $T_{ext} = T_{rad} - P_{rad} \cdot R_{th}$ and according to which, in step c, the maximum thermal power Prad max is equal to (Trad max - Text)/ Rth.

3. Method for controlling the temperature of a piece of sound reproduction equipment (10) according to claim 1 or 2, according to which the model of heat transfer within the piece of sound reproduction equipment is defined by the function $P_{rad} = (P_g - R_{rth}/R_g * T_{mes} - C_{th} * d(T_{mes})/dt))/(1 + R_{th}/R_g)$, where $R_g$ is the thermal resistance value between the piece of sound reproduction equipment in question as a source of heat and the outside of said piece of equipment, $T_{mes}$ is a measured temperature indicating the temperature of the radiator, $C_{th}$ is a capacity value representing the thermal energy storage and defining the temperature rise time, $d(T_{mes})/dt$ is the time derivative of $T_{mes}$.

4. Method according to any one of the preceding claims, according to which said steps are carried out cyclically, at a period T the value of which is within the range [0.1 s, 1 s].

5. Method according to any one of the preceding claims, according to which a command determined in step e comprises:

   - a maximum reproduction volume value of the audio signal, calculated as a function of the determined maximum thermal power to be emitted;
   - a maximum level at the output of the amplifier, calculated as a function of the determined maximum thermal power to be emitted;
   - an excursion limit value of the loudspeaker, calculated as a function of the determined maximum thermal power to be emitted.

6. Computer program comprising software instructions which, when they are executed by a computer, carry out a method according to any one of the preceding claims.

7. Electronic device (300) for controlling the temperature of a piece of sound reproduction equipment (10) comprising an input (12) for receiving an audio input signal to be reproduced, a loudspeaker (16) housed in an enclosure, a processing and amplification chain (14) comprising electronic components including at least an amplifier (26) capable of exciting the loudspeaker (16), and a radiator (18) adapted to dissipate the heat from the enclosure to the outside of the piece of equipment, said device being adapted to collect temperature data indicating the temperature of the radiator, to determine the thermal power $P_{rad}$ provided to the radiator by the components of the processing and amplification chain as a function of an evaluation of the thermal power $P_g$ emitted by at least the loudspeaker and by the components of the processing and amplification chain for the audio input signal to be reproduced, of said audio input signal to be reproduced and of a model of heat transfer within the piece of sound reproduction equipment, to estimate the temperature outside the piece of sound reproduction equipment (10) by means of a formula which gives the outside temperature $T_{ext}$ as a function of the temperature of the radiator $T_{rad}$ indicated by the collected data $T_{rad}$, of the determined thermal power supplied at the input of the radiator $P_{rad}$ and of the thermal resistance of the radiator $R_{th}$;
   said device being adapted to calculate the maximum thermal power $P_{rad\_max}$ which can be supplied to the radiator as a function of the estimated outside temperature and of a maximum radiator temperature threshold Trad max and as a function of said formula, to determine the maximum thermal power to be emitted by at least the loudspeaker and by the components of the processing and amplification chain for the audio input signal to be reproduced, as a function of the calculated maximum thermal power $P_{rad\_max}$ and of said model of heat transfer within the piece of sound reproduction equipment;
   said device being adapted to determine, as a function of said determined maximum thermal power to be emitted, at least one command for controlling the operation of the loudspeaker (16) or of the processing and amplification chain (14) such that the thermal power emitted by at least the loudspeaker and by the components of the processing and amplification chain for the audio input signal to be reproduced is below said determined maximum thermal power to be emitted.

8. Electronic device for controlling the temperature of a piece of sound reproduction equipment (10) according to claim 7, adapted to estimate the outside temperature as a function of the formula for estimating the outside temperature $T_{ext} = T_{rad} - P_{rad} \cdot R_{th}$ and adapted to determine the maximum thermal power $P_{rad\_max}$ as equal to $(T_{rad\_max} - T_{ext})/R_{th}$.

9. Electronic device for controlling the temperature of a piece of sound reproduction equipment (10) according to claim 7 or 8, wherein said model of heat transfer within the piece of sound reproduction equipment is defined by the function $P_{rad} = (P_g - R_{rth}/R_g * T_{mes} - C_{th} * d(T_{mes})/dt))/(1 + R_{th}/R_g)$, where $R_g$ is the thermal resistance value between the piece of sound reproduction equipment in question as a source of heat and the outside of said piece of equipment, $T_{mes}$ is a measured temperature indicating the temperature of the radiator, $C_{th}$ is a capacity value representing the thermal energy storage and defining the temperature rise time, $d(T_{mes})/dt$ is the time derivative of $T_{mes}$.

**10.** Electronic device for controlling the temperature of a piece of sound reproduction equipment (10) according to any one of claims 7 to 9, according to which said command comprises:

- a maximum reproduction volume value of the audio signal, calculated as a function of the determined maximum thermal power to be emitted;
- a maximum level at the output of the amplifier, calculated as a function of the determined maximum thermal power to be emitted;
- an excursion limit value of the loudspeaker, calculated as a function of the determined maximum thermal power to be emitted.

**11.** Piece of sound reproduction equipment (10) comprising an input (12) for receiving an audio input signal to be reproduced, a loudspeaker (16) housed in an enclosure, a processing and amplification chain (14) comprising electronic components including at least an amplifier (26) capable of exciting the loudspeaker (16), a radiator adapted to dissipate the heat from the enclosure to the outside of the piece of equipment, and an electronic device for controlling the temperature according to any one of claims 7 to 10.

EP 3 637 793 B1

FIG.1

$$FIG.2$$

$$FIG.3$$

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2873872

**Littérature non-brevet citée dans la description**

- **W. KLIPPEL.** *Nonlinear Modeling of the Heat Transfer in Loudspeakers*